(19)

Europäisches
Patentamt
European
Patent Office
Office européen
des brevets

(11) **EP 2 511 726 A1**

(12) **EUROPEAN PATENT APPLICATION**

(43) Date of publication:
**17.10.2012 Bulletin 2012/42**

(51) Int Cl.:
**$G01R\ 33/58$** (2006.01) **$G01R\ 33/44$** (2006.01)

(21) Application number: **11162302.1**

(22) Date of filing: **13.04.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Klinikum rechts der Isar der
Technischen
Universität München
81675 München (DE)**

(72) Inventor: **Ganter, Carl
82057 Icking-Dorfen (DE)**

(74) Representative: **Lucke, Andreas
Boehmert & Boehmert
Pettenkoferstrasse 20-22
80336 München (DE)**

(54) **A method and system for determining the flip angle in the transient phase of a gradient echo pulse sequence**

(57)     A method for determining the flip angle distribution in magnetic resonance imaging involves the acquisition of the signal in the transient phase of an unbalanced steady state free precession (SSFP) sequence. The actual flip angle may be determined by measuring the frequency of the damped oscillatory component of the deviation from steady state. The method according to the present invention allows to perform fast and accurate $B_1$ mapping with little dependence on tissue parameters and a good robustness against noise.

Fig. 1

EP 2 511 726 A1

**Description**

Field of the invention

The present invention relates to fast quantitative magnetic resonance imaging (MRI), and in particular to $B_1$-mapping by means of determining the actual flip angle distribution.

Background and related state of the art

Fast quantitative MRI has become an important tool for biochemical characterisation of tissue beyond conventional $T_1$, $T_2$, and $T_2^*$ weighted imaging. The ability to perform fast and accurate $B_1$-mapping is crucial for quantitative imaging, such as $T_1$-mapping, as well as for RF-pulse design, parallel excitation and chemical shift imaging.

The $B_1$-field strength is directly proportional to the actual flip angle, and hence $B_1$-mapping amounts to determining the current flip angle distribution over the object to be examined.

Conventional $B_1$-mapping methods are based either on signal magnitude or on signal phase. Examples of the former include alternating repetition times TR, variable flip angles, stimulated echoes etc., whereas examples of the latter include $2\alpha$-$\alpha$ excitation, adiabatic pulses, Bloch-Siegert Shift etc. All of these techniques conventionally rely on steady state properties, i.e. on measurement data acquired after a sequence of radiofrequency and gradient pulses has brought the magnetization into a dynamical equilibrium.

The methods currently in use have their specific merits and disadvantages, the latter of which comprising accuracy problems, e.g. dependence on $T_1$, $T_2$, $B_0$, or a limited $B_1$ range and methodological restrictions, e.g. complicated sequence design, long acquisition times, high SAR, etc.

An overview of relevant applications of $B_1$-mapping, currently available quantification techniques and their specific limitations can be found in the recent literature, e.g. in L. Sacolick et al., Magn Reson Med 2010;63:315 or V. Yarnykh, Magn Reson Med 2010;63:1610.

What is needed is a simple method for determining the flip angle or $B_1$ distribution that is both fast and accurate.

Overview of the present invention

The present invention achieves this objective with a method and system according to independent claims 1 and 13, respectively. The dependent claims relate to preferred embodiments.

A method for determining the flip angle in magnetic resonance imaging according to the present invention comprises the steps of irradiating an object to be examined with a periodic gradient echo sequence of radio-frequency and gradient pulses having a repetition time TR, acquiring a sequence of response signals representative of the magnetization of the object to be examined in response to said radiofrequency pulses, and analysing said acquired signal sequence in order to determine a flip angle distribution. Herein, said sequence of response signals is acquired in a transient phase of said gradient echo sequence. The flip angle distribution is determined based on a model, according to which the magnetizations represented by said sequence of response signals follow a time curve with oscillatory behaviour with an oscillation frequency f, wherein a flip angle $\alpha$ is approximated by $\alpha = TR \cdot f \cdot 360°$.

Note in this regard that the response signals provide discrete data points in time. In the present disclosure, the expression of the data points "following a time curve" is to be understood in the sense that a continuous curve interpolating said data points is oscillatory in time. For illustrative purpose, one could think of this as a discrete sampling of an oscillatory curve. Note, however, that even by decreasing the repetition time TR, the "sampling degree" would not increase, since the (angular) distance between consecutive data points always corresponds to the flip angle $\alpha$ and is hence independent from TR.

Further, in the present disclosure, the term "oscillatory behaviour" refers to both, a combination of sine/cosine-functions as well as rotations in the complex plane, without further mention. Also, the term "oscillatory behavior" shall mean that the time curve has at least an oscillatory component, but it may additionally have some time-independent offset. As is shown in greater detail below, the magnetization does not oscillate around zero, but obviously around a steady state value $m_\infty$. Nevertheless, even the magnetization curve as such is regarded as oscillatory, in spite of the offset $m_\infty$.

Finally, the wording "based on a model" and "approximated" expresses the fact that in practice, it may turn out that the flip angle $\alpha$ deviates from the product $TR \cdot f \cdot 360°$ by some empirically determined correction term. Even if it should turn out that small correction terms could be added to the equation, whether based on higher order calculations or empirical examination, this would still be regarded as being "based on the model" cited above.

A detailed derivation and explanation of the model underlying this novel flip angle determination technique will be presented below in the description of a detailed embodiment.

It is the surprising realization underlying the present invention that a more accurate, more reliable and faster $B_1$ mapping

can be achieved by determining the actual flip angle in a transient phase of the transversal magnetization. This approach deviates from all conventional techniques for determining the flip angle, which have exclusively focused on the steady state or dynamical equilibrium for echo excitation and signal acquisition. Before the work leading to the present invention, the steady state phase appeared to be more favourable for $B_1$ mapping, since a system in equilibrium was thought to be more susceptible to accurate and reliable measurements and also allows to increase the precision through data acquisition by means of repeated measurements. In contrast, the transient phase was thought to be too variable and too difficult to control in order to perform accurate measurements, and also too short for the complicated pulse sequences that were deemed necessary to increase the measurement accuracy. Against these prejudices, it was the realisation of the inventor that the frequency analysis of the response signal in the transient phase allows a reliable, quick and accurate determination of the actual flip angle, and hence the $B_1$ field strength.

According to the present invention, the signal is not acquired in the steady state of the transversal magnetization or gradient echo sequences, respectively. Rather, the signal is acquired in a transient phase of the transversal magnetization, or gradient echo sequence, respectively. A transient phase in the sense of the present invention may be an initial phase of the pulse sequence, i.e. a phase after the first radiofrequency pulse and before the transversal magnetization has reached a dynamical equilibrium. In other words, said signal may be acquired while a transversal magnetization approaches a dynamical equilibrium from some initial state, but has not yet reached said dynamical equilibrium.

A dynamical equilibrium in the sense of the present invention may be an equilibrium of the transversal magnetization in the presence of a static magnetic field and a sequence of radio-frequency pulses. In particular, said equilibrium may be an equilibrium in which a loss of transversal magnetization due to decay or relaxation is compensated by a gain of transversal magnetization created by irradiating an object to be examined with a sequence of radiofrequency pulses in the presence of a static magnetic field. A "transversal" direction in the sense of the latter embodiment and throughout this application may denote a direction perpendicular to the direction defined by the field vector of a static magnetic field. Hence, a transversal magnetization in the sense of the present invention is a magnetization represented by a vector or vectors perpendicular to the vector of the static magnetic field. Conventionally, the direction of the static magnetic field is defined as the Z axis of a Cartesian coordinate system. With this convention, a transversal magnetization may hence be a magnetization in the XY plane. Preferably, said step of analysing said signal may comprise the step of performing a frequency analysis of said acquired signal.

According to a preferred embodiment, the repetition time TR of said gradient echo sequence is between 0.5 ms and 10.0 ms, and in particular between 1.5 ms and 4.0 ms.

Preferably, said gradient echo sequence is a steady state free precession (SSFP) sequence, and in particular an unbalanced steady state free precession sequence.

Preferably, the acquired signal corresponds to single or several echoes of possibly different configuration orders. In a preferred embodiment, the signal is a free induction decay (FID) signal.

According to a preferred embodiment, said signal sequence may be acquired within a time span of below 500 times the repetition time TR of said sequence of radiofrequency pulses, said time span starting with the first radiofrequency pulse among said sequence of radiofrequency pulses.

In particular, said FID signal may be acquired within a time span of below 300 times said repetition time TR, and preferably below 200 times said repetition time TR.

The inventor further found that the deviation of the constant phase from the actual flip angle decreases with the ratio $TR / T_2$, wherein TR again denotes the repetition time of said sequence of radiofrequency pulses and $T_2$ denotes a time constant for the loss of transverse magnetization (transversal relaxation time). Hence, according to a preferred embodiment, said repetition time TR may be chosen such that $TR/T_2 < 1$.

In particular, it is advantageous to choose the repetition time TR of said sequence of radiofrequency pulses such that $TR/T_2 < 1$, preferably $TR/T_2 < 0.2$, and particularly $TR/T_2 < 0.1$.

The method according to the present invention may comprise a plurality of measurement blocks, wherein each measurement block comprises alternating steps of irradiating said object to be examined with radiofrequency and gradient pulses and acquiring a sequence of response signals. Each measurement block may preferably comprise 10 to 100 radio frequency pulses and a corresponding number of 10 to 100 signal acquisitions. Herein, said signal acquisitions alternate with said radiofrequency pulses.

The inventor found that it may further be advantageous to introduce a recovery period (or idle period) between a first measurement block and a second measurement block in order to reduce the overall bias and to improve the signal-to-noise ratio. Said recovery or idle period may preferably be longer than 50 ms, and in particular between 50 ms and 1000 ms.

According to a preferred embodiment, the method may further comprise a step of applying a magnetic field gradient pulse after at least one of said measurement blocks in order to remove a transverse magnetization. In particular, a first gradient may dephase the transversal magnetization, and an adiabatic pulse may subsequently convert a longitudinal magnetization into a transversal magnetization. Another gradient pulse may then again dephase the transversal magnetization.

The inventor found that a method according to the latter embodiment is particularly effective to remove any remaining magnetization prior to the recovery period, and hence allows a more accurate and more reliable determination of the flip angle in the subsequent measurement block. Applying an additional magnetic field gradient pulse according to the latter embodiment has the benefit that a shorter recovery period may be chosen without compromising the measurement accuracy.

According to a preferred embodiment, a frequency analysis for obtaining the aforementioned frequency f of the interrelated response signal sequence may be performed by employing a matrix pencil technique. A matrix pencil technique for frequency analysis is based on a singular value decomposition of a matrix composed of the acquired measurement data. The inventor found that by employing matrix pencil techniques rather than a more conventional Fourier analysis, the frequency analysis can be performed faster and the analysis is less sensitive to noise.

The present invention also relates to a method for performing $B_1$ mapping in magnetic resonance imaging, comprising a method for determining the flip angle distribution according to any of the previous embodiments and a step of determining the $B_1$-field from the determined flip angle distribution.

A system for determining the flip angle distribution in magnetic resonance imaging according to the present invention comprises a radiofrequency (RF) source adapted for irradiating an object to be examined with a periodic gradient echo sequence of radiofrequency pulses, having a repetition time TR, a receiver unit adapted for acquiring a response signal, and an evaluation unit adapted for analysing said response signal acquired by said receiver unit. Said system is adapted for acquiring said signal in a transient phase of said gradient echo sequence, and to determine the flip angle distribution based on a model according to which the magnetizations represented by said sequence of response signals follow a time curve with oscillatory behaviour with an oscillation frequency f, wherein a flip angle $\alpha$ is approximated $\alpha = TR \cdot f \cdot 360°$.

The system according to the present invention may be further adapted to implement a method with some or all of the features described above.

The invention further relates to a data storage device for use in a computer device suitable for controlling a device for magnetic resonance imaging, wherein said data storage device comprises computer readable instructions which, when run on said computer device, cause said computer device to implement on said device for magnetic resonance imaging a method with some or all of the features described above.

Detailed Description of Preferred Embodiments

The features and numerous advantages of the present invention will be best understood from a detailed description of preferred embodiments of the present invention in conjunction with the accompanying figures, in which

Fig. 1    shows a simulation diagram of the damped oscillatory component of the deviation from steady state, from which the flip angle can be determined;

Fig. 2    shows a diagram illustrating the relative difference between the flip angle and the transverse oscillatory component for various ratios of $T_2$/TR and $T_1$/TR; and

Fig. 3    shows the distribution of the effective flip angle in 16 sagittal planes, covering a volunteer's head, wherein the flip angle distribution has been acquired experimentally according to the method of the present invention.

Magnetic resonance imaging (MRI) is a well-known and well-established medical imaging technique that makes use of nuclear magnetic resonance (NMR) to image nuclei of atoms inside the body. No detailed account of the physics of magnetic resonance imaging will be given, since the underlying concepts and techniques of employing them for medical imaging are familiar to those skilled in the art. Nonetheless, to facilitate the understanding of the detailed description below, a short repetition of related concepts and definitions will be given in the following:

Radio-frequency (RF) pulses, which tilt the magnetization by a "flip angle" $\alpha$, are provided by application of transverse (relative to the longitudinal static main magnetic field $B_0$) time-dependent magnetic fields $B_1(t)$, satisfying certain resonance conditions. In practice, inevitable spatial variations of the transmit field $B_1(t)$ lead to identical relative variations of the "actual" flip angle $\alpha$. Therefore, determination of the actual flip angle can be used to investigate systematic fluctuations of the transmit field.

As a consequence of relaxation, any periodic sequence of radio-frequency (RF) and gradient pulses in presence of a static magnetic field finally leads to a "dynamic equilibrium" or "steady-state" of the magnetization. The approach toward dynamic equilibrium from any initial deviation from steady-state is usually referred to as "transient phase".

"Gradient echo" or "steady state free precession" (SSFP) sequences constitute a simple but important special case and are characterised by an equidistant sequence of RF pulses of constant flip angle $\alpha$, wherein the duration between consecutive excitation pulses is referred to as "repetition time" (TR). The phase $\varphi_\nu$ of the $\nu$-th RF pulse follows a phase cycling condition

$$\varphi_{v+1} - \varphi_v = \varphi + v \cdot \phi \qquad\qquad (1)$$

where the choice of values for $\varphi$ and $\phi$ depends on the SSFP variant. Nonzero values of $\phi$ refer to "RF spoiling", typically applied with the intention to suppress residual transverse magnetization prior to excitation. The total gradient moment **p**, accumulated in between any two consecutive RF pulses

$$\mathbf{p} = \gamma \int_0^{TR} dt\, \mathbf{G}(t) \qquad\qquad (2)$$

should be constant, i.e. not depend on the running index v. In Eq. (2), $\gamma$ refers to the gyromagnetic constant and $\mathbf{G}(t)$ denotes the time dependent gradient vector. In total, SSFP sequences can be subdivided into three families (with examples of vendor specific acronyms of subvariants):

    1. Balanced SSFP ($\mathbf{p} = \mathbf{0}$, $\phi = 0$), e.g. TrueFISP, b-FFE, FIESTA, etc.
    2. Unbalanced SSFP ($\mathbf{p} \neq \mathbf{0}$, $\phi = 0$), e.g. FISP, FFE, GRASS, PSIF, T2-FFE, CE-FAST, DESS, etc.
    3. Unbalanced SSFP with RF spoiling ($\mathbf{p} \neq \mathbf{0}$, $\neq 0$), e.g. FLASH, T1-FFE, SPGR, etc.

The combination $\mathbf{p} = \mathbf{0}$, $\phi \neq 0$ does not lead to a steady-state and is therefore not in use.

It is well known that the magnetization in a SSFP sequence can be thought of as composed of various so-called "configurations", discriminated by an integer valued so-called "configuration order" $n$. While all configurations contribute to the acquired signal of balanced SSFP sequences, only selected configurations are measured in unbalanced SSFP. The most important examples are the "FID" ($n = 0$: FISP, FFE, GRASS, FLASH, T1-FFE, SPGR, etc.) and the "ECHO" ($n = -1$: PSIF, T2-FFE, CE-FAST, etc.), but also combinations ($n = 0,-1$: e.g. DESS) or higher orders ($n > 1$: e.g. PRESTO) are in use. A detailed review of the theory of configurations can be found in K. Scheffler, Concept Magn Reson A 1999;11:291.

Techniques for determining the actual flip angle $\alpha$, and hence the $B_1$ field, have so far exclusively relied on steady state properties of SSFP or other sequences, in all cases based on the availability of more or less accurate mathematical solutions.

In contrast, the transient phase has not been considered for determining the actual flip angle, if only because its analytical properties were not understood sufficiently. Particularly for short TR, as commonly used in fast imaging, the transient phase of SSFP sequences exhibits an often striking complexity.

Only recently an analytical solution for a transient phase of SSFP sequences (including all three SSFP families mentioned above) has been derived in C. Ganter, "Analytical Solution to the Transient Phase of Steady State Free Procession Sequences", Magn Reson Med 2009;62:149.

The main results and their relevance for the present invention shall be sketched briefly:

Let $\mathbf{m}_v$ denote the magnetisation immediately after the v-th RF excitation pulse - expressed as an infinite dimensional configuration vector (i.e. including all configuration orders) - and $\mathbf{q}_v := \mathbf{m}_v - \mathbf{m}_\infty$ the associated deviation from steady-state. The unilateral z-transform of the latter, $\mathbf{q}(z)$, can be written as the product of a propagator matrix $\mathbf{G}(z)$ and the initial deviation $\mathbf{q}_0$,

$$\mathbf{q}(z) = \mathbf{G}(z)\, \mathbf{q}_0. \qquad\qquad (3)$$

The time dependent deviation can be recovered from a path integral

$$\mathbf{q}_v = \frac{1}{2\pi i} \int_\Gamma dz\; z^{v-1}\, \mathbf{G}(z)\, \mathbf{q}_0 \qquad\qquad (4)$$

where the contour Γ encloses the set of singularities **S** - typically branch cuts - of **G**(z).

Particularly for unbalanced SSFP sequences without RF spoiling (**p** ≠ **0**, ϕ = 0), the denominator of **G**(z) can be shown to vanish for a complex conjugate pair $z_0^{\pm} = c \cdot e^{\pm i\Omega}$, belonging to **S**. Since the divergence of **G**(z) dominates the response in Eq. (4), $\mathbf{q}_\nu$ effectively rotates by Ω from pulse to pulse, which can be observed as a damped (c < 1) oscillation in the signal. For Ω expressed in degrees, the period of the oscillation (in units of TR) is given by 360°/Ω. For example, a value of Ω = 40° corresponds to a periodicity of 9 TR cycles.

If we now define $\delta = TR/T_2$ as a small parameter, it can be shown theoretically that - up to corrections of O ($\delta^2$) - the phase Ω and the flip angle α are indeed essentially equivalent:

$$\alpha \approx \Omega \qquad\qquad\qquad (5)$$

The inventor of the present invention has realized that this allows to determine the actual flip angle α reliably and accurately from a frequency analysis of the damped oscillation, observed in the transient phase of an unbalanced SSFP sequence.

In the following, several remarks regarding the implementation of the method and preferred embodiments will be given:

- Theory shows that the damped oscillation, described by Eq. (5), can be observed in every configuration order. Therefore, the signal can be derived in principle from any configuration order or any combination of configuration orders. However, it might be the preferred embodiment, to base analysis on the FID signal, because of its maximal signal amplitude.

- Both, the complex and magnitude signal can be used for the frequency analysis. Both of these will be regarded as "oscillatory" in the wording used in the present disclosure.

- According to a preferred embodiment, the repetition time TR should be chosen as small as possible, to improve accuracy. Good results have been obtained for δ < 0.2 and particularly for δ < 0.1, which is compatible with conventional rapid imaging.

- In general, the number of acquired SSFP per transient phase may depend on the requirements to extract the phase Ω reliably from the recorded data. The frequency of oscillations is proportional to Ω, and hence less echoes may be required for larger Ω. Therefore, it may be favourable to use larger nominal flip angles α in the SSFP acquisition.

- Frequency analysis can be based on any suitable method. According to a preferred embodiment, the frequency analysis may be performed by employing a matrix pencil technique. A matrix pencil technique for frequency analysis is based on a singular value decomposition of a matrix composed of the acquired measurement data. The inventor found that by employing matrix pencil techniques rather than a more conventional Fourier analysis, the frequency analysis can be performed quicker and the analysis is less sensitive to noise.

- In general, it will be necessary to measure the transient phase several times, to obtain enough data for spatial reconstruction. A complete measurement will then typically consist in periodically alternating (**A**) a series of consecutive SSFP blocks during the transient phase with (**B**) suitable measures to disturb the steady-state prior to the next SSFP block. Regarding (**B**), several possibilities exist, three of which being as follows:

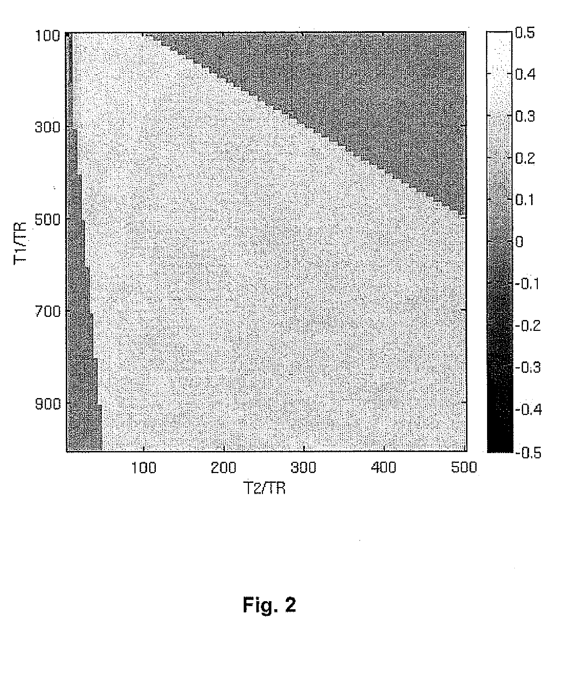

  ○ According to a preferred embodiment, the simplest approach is to introduce a break (idle time) to allow for (partial) recovery of longitudinal magnetization. The minimal achievable duration is essentially limited by SNR requirements, and will therefore depend strongly on the desired spatial resolution, encountered $T_1$ values and the sensitivity to noise of the method chosen for frequency analysis.
  ○ Alternatively or in addition, magnetization preparation can be helpful. According to a preferred embodiment, complete saturation (e.g. realised by: spoiler gradient - adiabatic 90° pulse - spoiler gradient) of magnetization immediately following the last SSFP block in (**A**) can improve the accuracy of the method, cf. Fig. 2. The latter embodiment has the additional benefit that a shorter recovery period may be chosen without compromising the measurement accuracy.
  ○ Due to its simplicity and flexibility, combination of the method with another measurement (imaging or quantification) in a hybrid sequence is believed to be possible.

- Measurement design offers considerable flexibility, e.g. with respect to

  ○ Excitation: selective / non-selective
  ○ Reconstruction: 3D / 2D
  ○ Acceleration techniques: reduced k-space sampling / parallel imaging

The method according to the present invention has been tested with computer simulations, and has also been successfully implemented experimentally in MRI tomography.

Based on an implementation of the configuration model, simulated transient phase data was calculated in Matlab 7.10 (The Mathworks, Inc., Natick, MA), allowing for freely adjustable noise corruption.

For sufficient repetitive deviation from steady state in the dynamical 3D MRI measurements (Achieva 1.5 T, Best, The Netherlands), synthetic triggers were applied to alternate trains of SSFP blocks (CINE phases) with idle periods (standard product sequence). Data was exported for offline post processing.

Any conventional techniques for frequency analysis can be employed in the context of the present invention in order to process the response signal and to determine the frequency of said damped oscillatory component. These may include standard Fourier analysis.

However, the inventor found that very favourable results may be achieved by employing algebraic methods of frequency analysis based on a singular value decomposition. In particular, analysis may be performed by means of the matrix pencil method described by Y. Y. Lin et al. in JMR 1997;128:30.

The method according to the present invention allows to employ the transient phase of unbalanced SSFP sequences for rapid and accurate $B_1$ mapping with good robustness against noise.

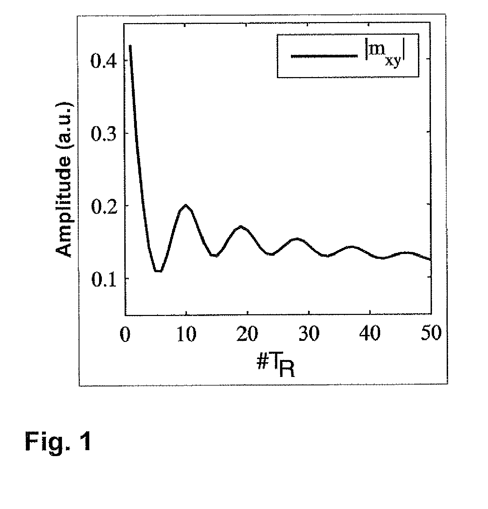

Fig. 1 shows the simulated magnitude of the damped complex oscillatory component of the deviation from steady state over 50 TR cycles with intermittent idle periods of duration 100 times TR. For the example illustrated in Fig. 1, the flip angle $\alpha$ has been chosen $\alpha = 40°$, and $T_1/T_2/TR = 150/15/1$.

Fig. 2 shows the relative difference (in %, with the shading indicating percental differences between -0.5 and 0.5%) between the actual flip angle $\alpha = 40°$ and the numerically determined constant phase $\Omega$, for $0.05 \leq T_2/T_1 \leq 1$ in a simulation without noise. As can be seen from Fig. 2, the overall bias without noise remains small (smaller than 0.5% in this example) for all relevant combinations of $T_1$ and $T_2$. Initial irregularities that are believed to be caused by a subtle delayed response effect can be avoided by adding a small number of dummy cycles. For example, in the simulation underlying Fig. 2, the first four of 40 echoes were excluded from the calculation of $\Omega$. After the SSFP acquisition period, residual magnetization was eliminated, followed by an idle period of 40 times TR. The inventor found that even better results can be obtained, and the idle period can be shortened, by introducing a saturation block immediately after the measurement block in order to destroy any remnant magnetization, such as a sequence of two gradient pulses with an adiabatic pulse in between, as described above.

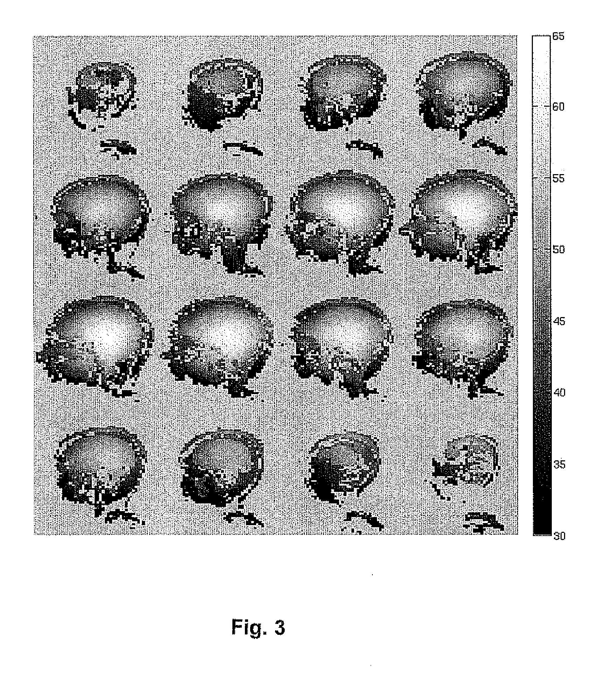

Fig. 3 shows an *in vivo* example of an effective flip angle measurement in 16 sagittal planes covering a volunteer's head according to the method of the present invention. The shading indicates flip angles between 30° and 65°. Parameters of the 3D measurement were $\alpha = 53°$, TR = 3.29 ms, 60 echoes (first five excluded), resolution = 5 x 5 x 10 mm, trigger interval = 0.5 s. Fig. 3 experimentally confirms that the tissue dependence is indeed negligible.

It is to be understood that the description and the figures merely serve to illustrate the present invention, but should not be interpreted to indicate any limitation. The scope of the invention is solely to be determined by the appended set of claims.

**Claims**

1. A method for determining the flip angle distribution in magnetic resonance imaging, comprising the steps of:

    irradiating an object to be examined with a periodic gradient echo sequence of radiofrequency pulses having a repetition time TR;
    acquiring a sequence of response signals representative of the magnetization of the object to be examined in response to said radiofrequency pulses;
    **characterized in that** said sequence of response signals is acquired in a transient phase of said gradient echo sequence, and
    that the flip angle distribution is determined based on a model, according to which the magnetizations represented by said sequence of response signals follow a time curve with oscillatory behaviour with an oscillation frequency f, wherein the flip angle $\alpha$ is approximated by $\alpha = TR \cdot f \cdot 360°$

2. The method according to claim 1, wherein said repetition time TR is between 0.5 ms and 10.0 ms, in particular between 1.5 ms and 4.0 ms.

3. The method according to claim 1 or 2, wherein said gradient echo sequence is an unbalanced steady-state free precession sequence.

4. The method according to the preceding claims, wherein acquiring said signal comprises acquiring a single or several echoes of possibly different configuration orders, preferably acquiring a single FID signal.

5. The method according to any of the preceding claims, wherein said signal is acquired in a non-equilibrium state.

6. The method according to any of the preceding claims, wherein said signal is acquired while a transversal magnetization approaches a dynamical equilibrium, but has not yet reached said dynamical equilibrium.

7. The method according to any of the preceding claims, wherein said signal is acquired within a time span of below 500 times a repetition time TR of said sequence of radiofrequency pulses, said time span starting with the first radiofrequency pulse among said sequence of radiofrequency pulses.

8. The method according to any of the preceding claims, wherein a repetition time TR of said sequence of radiofrequency pulses is chosen such that $TR/T_2 < 1$, wherein $T_2$ denotes the time constant for the loss of transverse magnetization.

9. The method according to claim 8, wherein $TR/T_2 << 1$, preferably $TR/T_2 < 0.2$, and particularly $TR/T_2 < 0.1$.

10. The method according to any of the preceding claims, comprising a plurality of measurement blocks, wherein each measurement block comprises alternating steps of irradiating said object with radiofrequency and gradient pulses and acquiring corresponding signals, wherein each measurement block preferably comprises 10 to 100 radiofrequency pulses and 10 to 100 corresponding signal acquisitions, said signal acquisitions alternating with said radiofrequency pulses.

11. The method according to claim 10, further comprising a recovery period between a first measurement block and a second measurement block, wherein said recovery period is preferably longer than 50 ms and in particular of a duration between 50 ms and 1000 ms.

12. The method according to claim 10 or 11, further comprising a step of applying a magnetic field gradient pulse after at least one of said measurement blocks to remove a transverse magnetization, and in particular a first gradient pulse for removing the transverse magnetization, an adiabatic pulse for converting a longitudinal magnetization into a transversal magnetization and a further gradient pulse.

13. A system for determining the flip angle distribution in magnetic resonance imaging, comprising:

    a RF source adapted for irradiating an object to be examined with a periodic gradient echo sequence of radiofrequency pulses having a repetition time TR;
    a receiver unit adapted for acquiring a sequence of response signals; and
    an evaluation unit adapted for analysing said sequence of response signals acquired by said receiver unit in order to determine a flip angle distribution;
    **characterized in that** said system is adapted for acquiring said sequence of signals in a transient phase of said gradient echo sequence, and
    **in that** said system is adapted to determine the flip angle distribution based on a model according to which the magnetizations represented by said sequence of response signals follow a time curve with oscillatory behaviour with an oscillation frequency f, wherein the flip angle $\alpha$ is approximated by $\alpha = TR \cdot f \cdot 360°$.

14. The system according to claim 13, further adapted to implement a method according to any of the claims 1 to 12.

15. A data storage device for use in a computer device suitable for controlling a device for magnetic resonance imaging, wherein said data storage device comprises computer-readable instructions which, when run on said computer device, cause said computer device to implement on said device for magnetic resonance imaging a method according to any of the claims 1 to 12.

Fig. 1

**Fig. 2**

Fig. 3

EUROPEAN SEARCH REPORT

Application Number

EP 11 16 2302

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| T | C.GANTER ET AL.: "B1-Mapping with the Transient Phase of SSFP", PROC.INTL.SOC.MAG.RESON.MED. 19, 23 April 2011 (2011-04-23), page 4427, XP000002658100, * the whole document * | | INV. G01R33/58 G01R33/44 |
| X,D | C. GANTER: "Analytical Solution to the Transient Phase of Steady-State Free Precession Sequences", MAGNETIC RESONANCE IN MEDICINE, vol. 62, 2009, pages 149-164, XP000002658101, * the whole document * | 1-15 | |
| A | C.K.ANAND ET AL.: "Steady State Spectroscopy - CW NMR Lives !", MOOT 2006, 19TH ANNUAL MOOT CONFERENCE 23-24 SEPTEMBER 2006, UNIVERSITY OF GUELPH, CANADA, 2006, XP000002658102, * the whole document * | 1-15 | |
| A | METZ K R ET AL: "RAPID ROTATING-FRAME IMAGING USING AN RF PULSE TRAIN (RIPT)", JOURNAL OF MAGNETIC RESONANCE. SERIES B, ACADEMIC PRESS, ORLANDO, FL, US, vol. 103, no. 2, 1 February 1994 (1994-02-01), pages 152-161, XP000429858, ISSN: 1064-1866, DOI: 10.1006/JMRB.1994.1023 * the whole document * -/-- | 1-15 | TECHNICAL FIELDS SEARCHED (IPC)<br><br>G01R |

The present search report has been drawn up for all claims

| Place of search | Date of completion of the search | Examiner |
|---|---|---|
| Munich | 7 September 2011 | Lersch, Wilhelm |

**EP 2 511 726 A1**

Europäisches Patentamt
European Patent Office
Office européen des brevets

## EUROPEAN SEARCH REPORT

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | TALAGALA S L ET AL: "EXPERIMENTAL DETERMINATION OF THREE-DIMENSIONAL RF MAGNETIC FIELD DISTRIBUTION OF NMR COILS", JOURNAL OF MAGNETIC RESONANCE, ACADEMIC PRESS, ORLANDO, FL, US, vol. 94, no. 3, 1 October 1991 (1991-10-01), pages 493-500, XP000235338, ISSN: 1090-7807 * the whole document * ----- | 1-15 | |
| A | I.J.LOWE ET AL.: "Homogeneous rf field delay line probe for pulsed nuclear magnetic resonance", REV.SCI.INSTRUM., vol. 48, 1977, pages 268-274, XP000002658103, * see chapter IIC * ----- | 1-15 | |

TECHNICAL FIELDS
SEARCHED      (IPC)

The present search report has been drawn up for all claims

| Place of search | Date of completion of the search | Examiner |
|---|---|---|
| Munich | 7 September 2011 | Lersch, Wilhelm |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **L. SACOLICK et al.** *Magn Reson Med,* 2010, vol. 63, 315
- **V. YARNYKH.** *Magn Reson Med,* 2010, vol. 63, 1610
- **K. SCHEFFLER.** *Concept Magn Reson A,* 1999, vol. 11, 291
- **C. GANTER.** Analytical Solution to the Transient Phase of Steady State Free Procession Sequences. *Magn Reson Med,* 2009, vol. 62, 149
- **Y. Y. LIN et al.** *JMR,* 1997, vol. 128, 30